Europäisches Patentamt

European Patent Office

Office européen des brevets

(11) Veröffentlichungsnummer: **0 217 119**
**A2**

(12) # EUROPÄISCHE PATENTANMELDUNG

(21) Anmeldenummer: 86111739.8

(22) Anmeldetag: 25.08.86

(51) Int. Cl.⁴: **H03M 1/80**

(30) Priorität: 23.09.85 DE 3533874

(43) Veröffentlichungstag der Anmeldung:
08.04.87 Patentblatt 87/15

(84) Benannte Vertragsstaaten:
AT CH DE FR GB IT LI NL SE

(71) Anmelder: **Siemens Aktiengesellschaft Berlin
und München**
**Wittelsbacherplatz 2**
**D-8000 München 2(DE)**

(72) Erfinder: **Rössler, Bernward, Dipl.-Ing.**
**Franz-Reber-Weg 6**
**D-8000 München 71(DE)**

(54) **Verfahren zur Digital-Analog-Wandlung digitaler Informationen in bipolare Analogsignale.**

(57) Es wird ein Netzwerk aus in ihrer Kapazität binär abgestuften Kondensatoren (C bis C'/16) verwendet, die je nach Binärwert des zugeordneten Bits eines zu wandelnden Digitalsignals mit ihren Fußpunkte des Netzwerks darstellenden Belegungen an eine Bezugsspannungsquelle (Vref) oder an Erdpotential geschaltet sind und damit den Wert der das Analogsignal darstellenden Ausgangsspannung des Netzwerks mitbestimmen oder nicht. Zur Erzielung einer monotonen und möglichst linearen Wandlerkennlinie bei der Wandlung in bipolare Signale wird das Netzwerk so betrieben, daß bei der Erzeugung gleichgroßer positiver und negativer Analogwerte jeweils dieselben Kondensatoren beteiligt sind.

FIG 2a

FIG 2c

FIG 2b

FIG 2d

## Verfahren zur Digital-Analog-Wandlung digitaler Informationen in bipolare Analogsignale.

Die Erfindung betrifft ein Verfahren zur Digital-Analog-Wandlung digitaler Informationen in bipolare Analogsignale unter Verwendung eines Netzwerks aus in ihrer Kapazität binär abgestuften Kondensatoren, deren Fußpunkte je nach dem Binärwert des Bits der digitalen Informationen, dem sie jeweils zugeordnet sind, an Erdpotential gelegt oder mit einer Bezugsspannungsquelle verbunden werden und damit nach einer Ladungsumverteilung den Wert der das Analogsignal darstellende Ausgangsspannung des Netzwerks mitbestimmen oder nicht.

Wenn Digital-Analog-Wandler (D/A-Wandler) als Bestandteil von nach dem Iterativ-Verfahren arbeitenden Analog-Digital-Wandlern (A/D-Wandler) eingesetzt sind, die ein hohes Auflösungsvermögen aufweisen sollen, dann werden an die Linearität der Wandlerkennlinie hohe Anforderungen gestellt.

Dasselbe gilt wenn D/A-Wandler Bestandteil eines Echokompensators sind, der im Zusammenhang mit der Datenübertragung zwischen Teilnehmerstation und Vermittlungsstelle eines Fernmeldesystems über eine Zweidrahtleitung im Vollduduplex-Betrieb eingesetzt ist. Nichtlinearitäten der Wandlerkennlinie sind nämlich im hohen Maße für die Güte der Echokompensation verantwortlich.

Bei einem bekannten D/A-Wandler der obengenannten Art, der also mit einem Netzwerk binär gewichteter Kondensatoren arbeitet und der Bestandteil eines A/D-Wandlers ist (High Speed CMOS A/D Conversion Techniques von William C.Black, Seiten 44 bis 53, 248 bis 249, Memorandum No. Ucb/Erl M80/54, Nov. 1980), ist die Erzeugung bipolarer Signale durch die Verwendung einer positiven und einer negativen Referenzspannung ermöglicht, siehe dortige Figur 3.17. Wenn diese Referenzspannungen nicht exakt gleich groß sind, entstehen Nichtlinearitäten geradzahliger Ordnung, zu deren Vermeidung ein Abgleich erforderlich ist.

Bei einem anderen in der genannten Literaturstelle beschriebenen D/A-Wandler für die Erzeugung bipolare Signale wird zwar lediglich eine einzige Referenzspoannung benötigt, dafür weist das Kondensatornetzwerk aber einen in seiner Kapazität höchstwertigen Kondensator auf, der bei der Erzeugung von Analogsignalen der einen Polarität eine Verschiebung der Wandlerkennlinie bewirkt, siehe dortige Fig. 3.19, womit für positive und negative Signale unterschiedliche Wandlerverhalten bedingt sind, also ebenfalls eine Nichtlinearität geradzahliger Ordnung vorliegt.

Bei noch einem anderen bekannten D/A-Wandler für bipolare Signale, der als Bestandteil eines Echokompensators eingesetzt ist und bei dem ebenfalls zwar nur eine Referenzspannungsquelle dafür aber ein Zusatzkondensator mit den geschilderten Auswirkungen auf die Linearität des Wandlers Verwendung findet, sind Maßnahmen getroffen, um den Einfluß der Nichtlinearitäten auf das Ergebnis der Echokompensation zu verringern, die darin liegen, daß einer der Kondensatoren des Kondensatornetzwerks im Zuge des Umwandlungsprozess in Abweichung vom Vorgehen bei den übrigen Kondensatoren nicht direkt an eine Bezugsspannungsquelle gelegt wird, sondern die Bezugsspannung über einen mit nichtlinearen Anzapfungen versehenen Spannungsteiler zugeführt bekommt (Large Scale Integration Of Hybrid-Method Digital Subscribr Loops von Oscar Ernesto Agazzi, Seite 161 bis 171, Memorandum Nr.Ucb/Erl M82/41,20 May 1982). Da die Toleranzen des erwähnten Zusatzkompensators, die im wesentlichen die Nichtlinearitäten des Wandlers bedingen, vorwiegend unsystematisch sind, ist die Eliminierung ihres Einflusses auf die Echokompensation mit den geschilderten Mitteln nur unter unverhältnismäßig großem Aufwand zu erreichen.

Die Aufgabe der vorliegenden Erfindung besteht daher darin, ein Verfahren zur D/A-Wandlung für die Erzeugung bipolarer Signale anzugeben, das gem. einer monotonen und möglichst linearen Wandlerkennlinie arbeitet, ohne daß hierzu Abgleichmaßnahmen erforderlich sind.

Diese Aufgabe wird mit einem Verfahren der eingangs genannten Art gelöst, das erfindungsgemäß dadurch gekennzeichnet ist, daß bei der Ladungsumverteilung zur Erzeugung gleich großer positiver und negativer Analogsignalwerte jeweils dieselben Kondensatoren beteiligt sind.

Gemäß einer weiteren Ausgestaltung der Erfindung ist eine Ausführungsform des erfindungsgemäßen Verfahren dadurch gekennzeichnet, daß in einem Vorbereitungsschritt die eine Belegung der Kondensatoren des Netzwerks, die deren Kopfpunkt darstellt, an Erdpotential und je nachdem ob der Wert des Vorzeichenbits der umzuwandelnden digitalen Information die Erzeugung eines positiven oder eines negativen Analogwerts erfordert, die andere Belegung und damit der Fußpunkt der Kondensatoren an die Bezugsspannungsquelle oder ebenfalls an Erdpotential gelegt und in einem nachfolgenden der Ladungsumverteilung dienenden Schritt die Kopfpunkte sämtlicher Kondensatoren von Erdpotential abgetrennt und die Fußpunkte der den Binärwert 1 aufweisenden Bits zugeordneten Kondenstoren an Erdpotential oder an die Bezugsspannungsquelle gelegt werden, wogegen die Fußpunkte der übrigen Kondensatoren an die Bezugsspannungsquelle oder an Erdpotential gelegt werden.

Ein D/A-Wandler, der in dieser Art arbeitet, ist besonders als Bestandteil eines nach dem Iterativ-Verfahren arbeitenden A/D-Wandlers geeignet.

Gemäß einer anderen weiteren Ausgestaltung der Erfindung ist eine Ausführungsform des erfindungsgemäßen Verfahrens dadurch gekennzeichnet, daß in einem Vorbereitungsschritt, je nachdem ob der Wert des Vorzeichenbits der umzuwandelnden digitalen Information die Erzeugung eines positiven oder eines negativen Analogwerts erfordert, der Fußpunkt des dem Vorzeichenbit zugeordneten Kondensators und derjenigen Kondensatoren, die den Binärwert O aufweisenden Bits zugeordnet sind, an Erdpotential oder an die Bezugsspannungsquelle und die Fußpunkte der übrigen den den Binärwert 1 aufweisenden Bits zugeordneten Kondensatoren an die Bezugsspannungsquelle oder an Erdpotential und in einem nachfolgenden, der Ladungsumverteilung dienenden Schritt die den Binärwert 1 aufweisenden Bits zugeordneten Kondensatoren ebenfalls an Erdpotential oder ebenfalls an die Bezugsspannungsquelle gelegt werden.

Diese Ausführungsform des erfindungsgemäßben Verfahren ist besonders dann von Vorteil, wenn der D/A-Wandler zum Analogteil eines Echokompensators gehört, in dem eine D/A-Wandlung eines Kompensationssignals, die eigentliche Kompensation sowie eine A/D-Wandlung des Restechosignals zur Korrektur der Einstellung des Transversalfilters des Echo kompensators abgewickelt wird.

In allen Fällen ist bei dem zur Durchführung verwendeten D/A-Wandler mit Kondensatorenetzwerk nur eine Bezugsspannungsquelle erforderlich und eine Zusatzkapazität, die, wie geschildert, die Ursache für Nichtliniaritäten sein könnte, vermieden.

Nachstehend wird die Erfindung anhand von zwei Ausführungsbeispielen unter Bezugnahme auf eine Zeichnung näher erläutert.

In der Zeichnung zeigen:

Die Figuren 1a bis 1c ein Netzwerk aus in ihrer Kapazität binär abgestuften Kondensatoren zur Durchführung des erfindungsgemäßen Verfahrens in vier verschiedenen Betriebszuständen gem. einer ersten Verfahrensvariante.

Die Figuren 2a bis 2c dasselbe Netzwerk in vier verschiedenen Betriebszuständen gem. einer zweiten Verfahrensvariante.

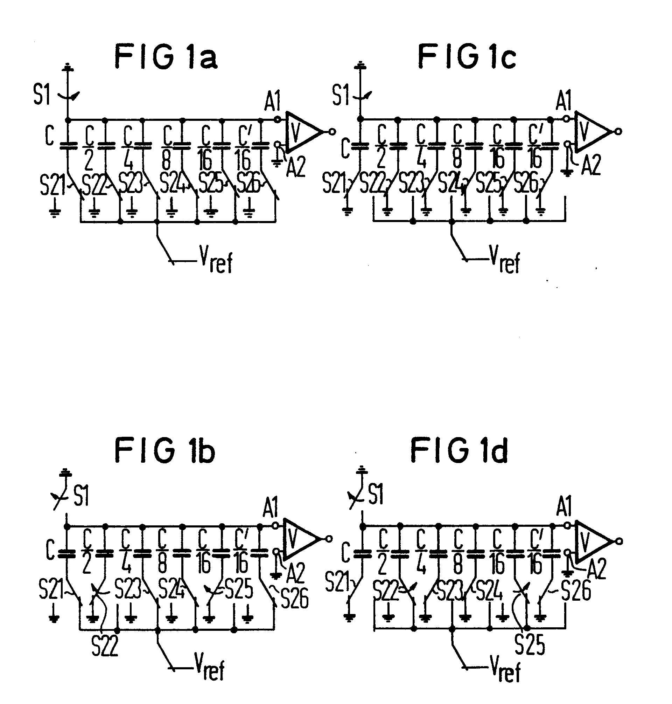

Ein Kondensatornetzwerk, wie es zur Durchführung des erfindungsgemäßen Verfahrens Verwendung findet, besteht, wie beispielsweise die Figur 1a zeigt, aus einer Anzahl von Kondensatoren, die in ihrer Kapazität binär abgestuft sind, also die Kapazitätswerte $C$, $C/2$, $C/4$ usw. $C/16$ aufweisen und entsprechend ihrer Kapazität jeweils einem höher-oder niedrigerwertigem Bit eines einerD/A-Wandlung zu unterwerfenden Digitalsignals zugeordnet sind. Darüberhinaus ist ein weiterer Kondensator mit dem niedrigsten Kapazitätswert $C/16$ vorhanden, der mit $C'/16$ bezeichnet ist.

Die einen Belegungen der Kondensatoren, die Kopfpunkte des Netzwerks darstellen, können über einen Schalter $S1$ mit Erdpotential verbunden werden. Die anderen Belegungen dieser Kondensatoren, die Fußpunkte des Netzwerks darstellen, sind über jeweils gesonderte Schalter $S21$ bis $S26$ mit einem Erdpotential führenden Schaltungspunkt oder mit einer Bezugsspannungsquelle verbindbar, die die Bezugsnung $V_{ref}$ liefert.

Zwischen einer Ausgangsklemme $A1$, die an den miteinander verbundenen Belegungen der Kondensatoren liegt, und einer auf Erdpotential liegenden Klemme $A2$ kann bei diesem Netzwerk eine Ausgangsspannung abgenommen werden, die die Eingangsspannung eines Operationsverstärkers $V$ bildet.

Die Figur 1a zeigt den Betriebszustand des Kondensatornetzwerkes nach einem Vorbereitungsschritt zur Erzeugung eines negativen Analogwerts entsprechend dem Binärwert des Vorzeichenbits der umzuwandelnden digitalen Information. Es sind demnach über dem Schalter $S1$ die miteinander verbundenen Belegungen der Kondensatoren, die Kopfpunkte des Netzwerks bilden, an Erdpotential gelegt, die Fußpunkte der Kondensatoren liegen über die Schalter $S21$ bis $S26$ an der Bezugsspannung $V_{ref}$. Die solcher Art parallel geschalteten Kondensatoren werden damit auf die Ladung $Q_x = -2C° V_{ref}$ aufgeladen, da die Summe der Kapazitätswerte sämtlicher Kondensatoren gerade den Kapazitätswert $2C$ ergibt. In dem nachfolgenden der Ladungsumverteilung dienenden Schritt werden nun durch Betätigung des Schalters $S1$ die Kopfpunkte der Kondensatoren von Erdpotential abgetrennt und die Fußpunkte derjenigen Kondensatoren, die den Binärwert 1 aufweisenden Bits in der umzuwandelnden Digitalinformation zugeordnet sind, durch Betätigung der entsprechenden Schalter an Erdpotential gelegt. Bei dem angenommenen Beispiel, siehe Fig. 1b, sind dies der die Kapazität $C/2$ aufweisende Kondensator, der dem nach dem Vorzeichenbit höchstwertigen Bit zugeordnet ist, sowie der die Kapazität $C/16$ aufweisende Kondensator, der dem nied-rigstwertigen Bit der digitalen Information zugeordnet ist. Der zweite die Kapazität $C/16$ aufweisende Kondensator $C'/16$ sowie alle übrigen Kondensatoren verbleiben mit ihren Fußpunkten an der Bezugsspannung $V_{ref}$.

Die Ausgangsspannung des Kondensatornetzwerks zwischen den Ausgangsklemmen A1 und A2, die bisher den Wert Vx = O gehabt hat, ändert sich dabei auf den Wert Vx

$$= -\frac{C/2 + C/16}{2C} \; Vref.$$

Diese Ausgangsspannung stellt den der angenommenen Digitalinformation entsprechenden Analogwert dar.

Ist aufgrund des Vorzeichenbits der umzuwandelnde Digitalinformation ein positiver Analogwert zu erwarten, dann besteht, wie Fig. 1c zeigt, der Vorbereitungsschritt darin, daß durch Betätigung der Schalter S1 und S21 bis S26 sowohl die Kopfpunkte als auch die Fußpunkte der Kondensatoren des Netzwerks an Erdpotential gelegt werden.

Im darauffolgenden Schritt werden dann die Kopfpunkte der Kondensatoren durch Betätigung des Schalters S1 von Erdpotential abgetrennt und, wieder unter der Voraussetzung, daß das in der Wertigkeit zweithöchste und niedrigste Bit der umzuwandelnden Digitalinformation den Binärwert 1 aufweisen, die Fußpunkte des die Kapazität C/2 und des einen die Kapazität C/16 aufweisenden Kondensators durch Betätigung der Schalter S22 und S25 an die Bezugsspannung Vref gelegt, wogegen die Fußpunkte der übrigen Kondensatoren an Erdpotential verbleiben. Die Ausgangsspannung zwischen den Ausgangsklemmen A1 und A2 ändert sich dabei vom Wert Vx = O auf den Wert

$$Vx = \frac{C/2 + C/16}{2C} \; Vref.$$

Aus den obenstehenden Erläuterungen erkennt man, daß beim erfindungsgemäßen Umwandlungsverfahren für die Darstellung eines positiven und eines negativen Analogwertes die Kondensatoren des Kondensatornetzwerks jeweils gleiche Gruppen bilden, die Wandlerkennlinie also symmetrisch zum Nullpunkt ist und damit Nichtlinearitäten erster Ordnung vermieden sind.

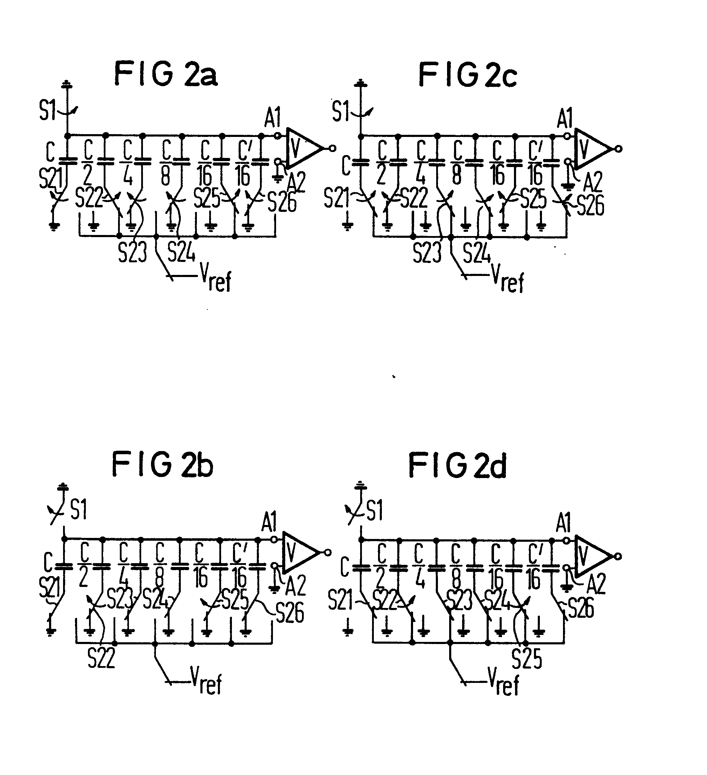

Anhand der Figuren 2a bis 2d wird nunmehr eine zweite Ausführungsvariante des erfindungsgemäßen Verfahrens näher erläutert. In diesen Figuren ist wiederum ein Netzwerk aus in ihrer Kapazität binär gestuften Kondensatoren dargegellt, das dem in den Figuren 1a bis 1d dargestellten Netzwerk gleicht, jedoch, wie die nachfolgenden Ausführungen ergeben werden, in abweichender Weise betrieben.wird.

Wenn aufgrund des Vorzeichenbits einer digitalen Information die Abgabe eines negativen Analogsignalwertes zu erwarten ist, dann werden, wie die Figur 2a zeigt, in einem Vorbereitungsschritt die Kopfpunkte der Kondensatoren durch Betätigung des Schalters S1 an Erdpotential gelegt. Die Fußpunkte der Kondensatoren, sofern sie den Binärwert O aufweisenden Bits der digitalen Information zugeordnet sind, werden an Erdpotential gelegt, hier also die Fußpunkte der Kondensatoren C/4 und C/8. Dasselbe gilt für den Fußpunkt des Kondensators C, der dem Vorzeichenbit zugeordnet ist und denjenigen des Kondensators C'/16. Die Fußpunkte der restlichen Kondensatoren, also derjenigen, die den Binärwert 1 aufweisenden Bits zugeordnet sind, hier der Kondensatoren C/2 und C/16 sind über die entsprechenden Schalter S22 und S25 an die Bezugsspannung Vref gelegt.

In einem nachfolgenden, der Ladungsumverteilung dienenden Schritt werden dann die Fußpunkte der letztgenannten Kondensatoren C/2 und C'/16 von der Bezugsspannung abgetrennt und ebenfalls an Erdpotential gelegt, siehe Fig. 2b. Zwischen den Ausgangsklemmen A1 und A2 wechselt dabei die Ausgangsspannung von Vx = O auf

$$Vx = -\frac{C/2 + C/16}{2C} \; Vref.$$

Wenn aufgrund des Vorzeichenbits positive Analogsignalwerte erwartet werden, besteht, wie die Figur 2c zeigt, bei dieser zweiten Variante des erfindungsgemäßen Verfahrens die Vorbereitung darin, daß wie bisher die Kopfpunkte der Kondensatoren über den Schalter S1 an Erdpotential gelegt werden, in Abweichung von den zuvor geschilderten Verhältnissen jedoch die Fußpunkte des dem Vorzeichenbit zugeordneten Kondensators, derjenigen Kondensatoren, die den Binärwert O aufweisenden Bits zugeordnet sind, hier der Kondensatoren C/4 und C/8, sowie des unabhängig vom Binärwert des niedrigstwertigen Bits betriebenen Kondensators C'/16 an die Bezugsspannung Vref gelegt werden, wogegen die Bits mit dem Binärwert 1 zugeordneten Kondensatoren, hier die Kondensatoren C/2 und C/16 mit ihren Fußpunkten an Erdpotential gelegt werden.

Im zweiten, dem Ladungsumverteilungsschritt, werden die Fußpunkte der letzgenannten Kondensatoren C/2 und C/16 ebenfalls an die Bezugsspannungsquelle angeschlossen, womit zwischen den Ausgangsklemmen A1 und A2 die Ausgangsspannung

$$Vx = \frac{C/2 + C/16}{2C} \ Vref$$

anliegt, die den dem umzuwandelnden Digitalsignal entsprechenden Analogsignalwert darstellt.

Bezugszeichenliste C bis C/16 ...........Kondensator

C'/16 ................Kondensator

S1....................Schalter

S21 bis S26 ..........Schalter

Vref.................Bezugsspannung

A1....................Ausgangsklemme

A2.........⌄..........Klemme

V....................Operationsverstärker

## Ansprüche

1. Verfahren zur Digital-Analog-Wandlung digitaler Informationen in bipolarer Analogsignale unter Verwendung eines Netzwerks aus in ihrer Kapazität binär abgestuften Kondensatoren, deren Fußpunkte je nach dem Binärwert des Bits der digitalen Informationen, dem sie jeweils zugeordnet sind, an Erdpotential gelegt oder mit einer Bezugsspanquelle verbunden werden und damit nach einer Ladungsumverteilung den Wert der das Analogsignal darstellenden Ausgangsspannung des Netzwerks mitbestimmen oder nicht, **dadurch gekennzeichnet, daß**

bei der Ladungsumverteilung zur Erzeugung gleich großer positiver und negativer Analogwerte jeweils dieselben Kondensatoren (C bis C/16) beteiligt sind.

2. Verfahren nach Patentanspruch 1,

**dadurch gekennzeichnet, daß**

in einem Vorbereitungsschritt die eine Belegung der Kondensatoren (C bis C'/16) des Netzwerks, die deren Kopfpunkt darstellt, an Erdpotential und je nachdem ob der Wert des Vorzeichenbits der umzuwandelnden digitalen Information die Erzeugung eines positiven oder eines negativen Analogwerts erfordert, die andere Belegung und damit die Fußpunkte der Kondensatoren an die Bezugsspannungsquelle (Vref) oder an Erdpotential gelegt und in einem nachfolgenden, der Ladungsumverteilung dienenden Schritt die Kopfpunkte darstellenden Belegungen sämtlicher Kondensatoren von Erdpotential abgetrennt und die Fußpunkte darstellenden Belegungen der den Binärwert 1 aufweisenden Bits zugeordneten Kondensatoren (z.B. C/2 und C/16) an Erdpotential oder an die Bezugsspannungsquelle (Vref) gelegt werden, wogegen die Fußpunkte darstellenden Belegungen der übrigen Kondensatoren an die Bezugsspannungsquelle oder an Erdpotential gelegt bleiben.

3. Verfahren nach Patentanspruch 1,

**dadurch gekennzeichnet, daß**

in einem Vorbereitungsschritt die Kopfpunkte des Netzwerks darstellenden Belegungen der Kondensatoren (C bis C/16) an Erdpotential gelegt werden und je nachdem ob der Wert des Vorzeichenbits der umzuwandelnden digitalen Information die Erzeugung eines positiven oder eines negativen Analogwerts erfordert, die Fußpunkte darstellenden Belegungen des dem Vorzeichenbit zugeordneten Kondensators (C) und derjenigen Kondensatoren (z.B. C/4, C/8), die den Binärwert O aufweisenden Bits zugeordnet sind, sowie eines weiteren Kondensators (C'/16) derselben Kapazität wie der dem niedrigstwertigen Bit digitaler Informationen zugeordnete Kondensator (C/16) an Erdpotential oder an die Bezugsspannungsquelle (Vref) und die Fußpunkte darstellenden Belegungen der den Binärwert 1 aufweisenden Bits zugeordneten Kondensatoren (z.B. C/2, C/16) an die Bezugsspannungsquelle oder an Erdpotential gelegt und in einem nachfolgenden, der Ladungsumverteilung dienenden Schritt die Kopfpunkte darstellenden Belegungen der Kondensatoren ( C bis C'/16) von Erdpotential ab getrennt und die Fußpunkte darstellenden Belegungen der den Binärwert 1 aufweisenden Bits zugeordneten Kondensatoren (z.B. C/2, C/16) ebenfalls an Erdpotential oder ebenfalls an die Bezugsspannungsquelle (Vref) gelegt werden.

0 217 119

FIG 1a

FIG 1c

FIG 1b

FIG 1d

FIG 2a

FIG 2c

FIG 2b

FIG 2d